# EUROPEAN PATENT APPLICATION

(11) **EP 2 292 354 A2**
(43) Date of publication of application: **09.03.2011**
(21) Application number: 10173858.1
(22) Date of filing: 24.08.2010
(51) Int. Cl.: B22F 1/00, B22F 9/24

(54) **Method for preparing stabilized metal nanoparticles**

(30) Priority: 04.09.2009 US 554601
(71) Applicant: Xerox Corporation, Rochester, New York 14644 (US)
(72) Inventor: Liu, Ping, Mississauga Ontario L5M 3H2 (CA); Wu, Yiliang, Oakville Ontario L6H 0C6 (CA); Hu, Nan-Xing, Oakville Ontario L6H 7V3 (CA)
(74) Representative: De Anna, Pier Luigi

(57) **Abstract**

A process for preparing stabilized metal nanoparticles, the process comprising reacting a metal compound with a reducing agent in the presence of a stabilizer in a reaction mixture comprising the metal compound, the reducing agent, and the stabilizer, wherein the reaction mixture is substantially free of solvent, to form a plurality of metal-containing nanoparticles during the solvent-free reduction process with molecules of the stabilizer on the surface of the metal-containing nanoparticles.

## Description

### BACKGROUND

Disclosed herein is a process for preparing stabilized metal nanoparticles, in embodiments, a method for preparing organoamine-stabilized silver nanoparticles during a solvent-free reduction process, having increased stability for conducting ink applications. In embodiments, the method comprises a chemical reduction of silver acetate with a reducing agent, such as phenyl hydrazine, in the presence of organoamine stabilizers. The metal nanoparticles prepared by the present method are much more stable than metal nanoparticles prepared using previous methods. Further, the present method substantially eliminates environmentally harmful solvents such as toluene from the chemical reaction process, which further reduces production cost. The metal nanoparticles thus prepared have a longer shelf life and lower annealing temperature than metal nanoparticles prepared using previous methods.

Fabrication of electronic circuit elements using liquid deposition techniques are of interest as such techniques provide potentially low-cost alternatives to conventional amorphous silicon technologies for electronic applications such as thin film transistors (TFTs), light-emitting diodes (LEDs), radio-frequency identification (RFID) tags, photovoltaics, among others. However, the deposition and patterning of functional electrodes, pixel pads, and conductive traces, lines and tracks which meet the conductivity, processing, and cost requirements for practical applications can be a challenge. Silver is of particular interest as a conductive element for electronic devices because silver is much lower in cost than gold and silver possess much better environmental stability than copper.

U. S. Patent 7,270,694, discloses a process comprising reacting a silver compound with a reducing agent comprising a hydrazine compound in the presence of a thermally removable stabilizer in a reaction mixture comprising the silver compound, the reducing agent, the stabilizer, and an optional solvent, to form a plurality of silver-containing nanoparticles with molecules of the stabilizer on the surface of the silver-containing nanoparticles.

U. S. Patent 7,494,608, discloses a composition comprising a liquid and a plurality of silver-containing nanoparticles with a stabilizer, wherein the silver-containing nanoparticles are a product of a reaction of a silver compound with a reducing agent comprising a hydrazine compound in the present of a thermally removable stabilizer in a reaction mixture comprising the silver compound, the reducing agent, the stabilizer, and an organic solvent wherein the hydrazine compound is a hydrocarbyl hydrazine, a hydrocarbyl hydrazine salt, a hydrazide, a carbazate, a sulfonohydrazide, or a mixture thereof, and wherein the stabilizer includes an organoamine.

While currently available methods for preparing conductive elements for electronic devices are suitable for their intended purposes, there remains a need for an improved system and method suitable for preparing conductive structures. Further, a need remains for lower cost, environmentally safe methods for preparing liquid processable, stable silver-containing nanoparticle compositions that are suitable for fabricating electrically conductive elements of electronic devices. Further, a need remains for metal-containing nanoparticles compositions having increased shelf life and lower annealing temperatures than currently available.

The appropriate components and process aspects of the each of the foregoing U. S. Patents and Patent Publications may be selected for the present disclosure in embodiments thereof. Further, throughout this application, various publications, patents, and published patent applications are referred to by an identifying citation.

### SUMMARY

Described is a process for preparing stabilized metal nanoparticles comprising reacting a metal compound with a reducing agent in the presence of a stabilizer in a reaction mixture comprising the metal compound, the reducing agent, and the stabilizer, wherein the reaction mixture is substantially free of solvent, to form a plurality of metal-containing nanoparticles during the solvent-free reduction process with molecules of the stabilizer on the surface of the silver-containing nanoparticles.

Also described is a composition comprising a liquid and a plurality of metal-containing nanoparticles with a stabilizer attached on the surface of the metal-containing nanoparticles, wherein the metal-containing nanoparticles are the product of a reaction of a metal compound with a reducing agent in the presence of a stabilizer in a reaction mixture comprising the metal compound, the reducing agent, and the stabilizer, wherein said reaction mixture is substantially free of solvent.

Further described is a process for forming a conductive metal framework comprising reacting a metal compound with a reducing agent in the presence of a thermally removable stabilizer in a reaction mixture comprising the metal compound, the reducing agent, and the stabilizer, wherein said reaction mixture is substantially free of solvent, to form a plurality of metal-containing nanoparticles during the solvent-free reduction process with molecules of the stabilizer on the surface of the metal-containing nanoparticles; isolating the plurality of metal-containing nanoparticles with the molecules of the stabilizer on the surface of the metal-containing nanoparticles; preparing a composition including a liquid and the plurality of metal-containing nanoparticles with molecules of the stabilizer on the surface of the metal-containing nanoparticles; depositing the composition including a liquid and the plurality of metal-containing nanoparticles with molecules of the stabilizer on the surface of the metal-containing nanoparticles on a substrate by a liquid deposition technique to form a deposited composition; and heating the deposited composition to form an electrically conductive layer comprising metal. In embodiments, the heating is accomplished at a temperature below about 130 °C.

### DETAILED DESCRIPTION

A process for preparing stabilized metal nanoparticles is disclosed. The process comprises reacting a metal compound with a reducing agent in the presence of a stabilizer in a reaction mixture comprising the metal compound, the reducing agent, and the stabilizer, wherein the reaction mixture is substantially free of solvent, to form a plurality of metal-containing nanoparticles during the solvent-free reduction process with molecules of the stabilizer on the surface of the metal-containing nanoparticles. Also disclosed is a composition comprising a liquid and a plurality of metal-containing nanoparticles with a stabilizer attached on the surface of the metal-containing nanoparticles, wherein the metal-containing nanoparticles are the product of a reaction of a metal compound with a reducing agent in the presence of a stabilizer in a reaction mixture comprising the metal compound, the reducing agent, and the stabilizer, wherein said reaction mixture is substantially free of solvent.

Further disclosed is a process for forming a conductive metal framework comprising reacting a metal compound with a reducing agent in the presence of a thermally removable stabilizer in a reaction mixture comprising the metal compound, the reducing agent, and the stabilizer, wherein said reaction mixture is substantially free of solvent, to form a plurality of metal-containing nanoparticles during the solvent-free reduction process with molecules of the stabilizer on the surface of the metal-containing nanoparticles; isolating the plurality of metal-containing nanoparticles with the molecules of the stabilizer on the surface of the metal-containing nanoparticles; preparing a composition including a liquid and the plurality of metal-containing nanoparticles with molecules of the stabilizer on the surface of the metal-containing nanoparticles; depositing the composition including a liquid and the plurality of metal-containing nanoparticles with molecules of the stabilizer on the surface of the metal-containing nanoparticles on a substrate by a liquid deposition technique to form a deposited composition; and heating the deposited composition to form an electrically conductive layer comprising metal.

Further disclosed is an electronic device comprising, in any suitable sequence, a substrate, an optional insulating layer, an optional semiconductor layer, or a combination of optional insulating layer and optional semiconductor layer, and an electrically conductive element of the electronic device, wherein the electrically conductive element comprises annealed metal-containing nanoparticles, wherein the metal-containing nanoparticles are the product of a reaction of a metal compound with a reducing agent in the presence of a stabilizer in a reaction mixture comprising the metal compound, the reducing agent, and the stabilizer, wherein said reaction mixture is substantially free of solvent.

In embodiments, a thin film transistor circuit is provided comprising an array of thin film transistors including electrodes, connecting conductive lines and conductive pads, wherein the electrodes, the connecting conductive lines, or the conductive pads, or a combination of thereof, comprise annealed metal-containing nanoparticles, wherein the metal-containing nanoparticles are a product of a reaction of a metal compound with a reducing agent comprising a hydrazine compound in the presence of a thermally removable stabilizer in a reaction mixture that is substantially free of solvent comprising the metal compound, the reducing agent, and the stabilizer.

In further embodiments, a thin film transistor is provided comprising an insulating layer, a gate electrode, a semiconductor layer, a source electrode, and a drain electrode, wherein the insulating layer, the gate electrode, the semi-conductor layer, the source electrode, and the drain electrode are in any sequence as long as the gate electrode and the semiconductor layer both contact the insulating layer, and the source electrode and the drain electrode both contact the semiconductor layer, and wherein at least one of the source electrode, the drain electrode, and the gate electrode comprises annealed metal-containing nanoparticles, wherein the metal-containing nanoparticles are a product of a reaction of a metal compound with a reducing agent comprising a hydrazine compound in the presence of a thermally removable stabilizer in a reaction mixture that is substantially free of solvent comprising the metal compound, the reducing agent, and the stabilizer.

Any suitable metal compound can be used for the process herein. In embodiments, the metal compound comprises a metal salt selected from the group consisting of metal acetate, metal trifluoroacetate, metal halide, metal sulfate, metal nitrate, metal hydrocarbylsulfonate, or a mixture thereof.

Any suitable reducing agent can be used for the process herein. In embodiments, the reducing agent includes a boron compound or a hydrazine compound. In embodiments, the hydrazine compound includes a hydrazine or any suitable derivatives thereof, substituted at one or both nitrogen atoms where each nitrogen atom can be substituted one or two times with the same substituent or with a different substituent, as well as salts and hydrates of hydrazine and salts and hydrates of the hydrazine derivatives. It is understood that the exemplary compounds described herein for the hydrazine compound also include the hydrate form where applicable. For example, the compound "hydrazine" includes hydrazine hydrate and hydrazine not in hydrated form. Exemplary examples of the hydrazine compound include hydrazine having the formula

H₂HNH₂;

hydrazine salts such as hydrazine acid tartrate, hydrazine monohydrobromide, hydrazine monohydrochloride, hydrazine dichloride, hydrazine monooxalate, and hydrazine sulfate;

hydrocarbyl hydrazine, for example having the formula

RNHNH₂;

RNHNHR;

or

RRNNH₂

wherein one nitrogen atom is mono- or di-substituted with R, and the other nitrogen atom is optionally mono- or di-substituted with R, wherein each R is an independently selected hydrocarbon group such as methyl, ethyl, propyl, butyl, hydroxyethyl, phenyl, benzyl, tolyl, bromophenyl, chlorophenyl, nitrophenyl, xylyl, and the like. Illustrative examples of hydrocarbylhydrazine include methylhydrazine, tert-butylhydrazine, 2-hydroxyethylhydrazine, benzylhydrazine, phenylhydrazine, tolylhydrazine, bromophenylhydrazine, chlorophenylhydrazine, nitrophenylhydrazine, 1,1-dimethylhydrazine, 1,1-diphenylhydrazine, 1,2-diethylhydrazine, and 1,2-diphenylhydrazine; wherein in a specific embodiment, the reducing agent is phenylhydrazine;

hydrocarbyl hydrazine salt, which is a salt of the hydrocarbyl hydrazine described herein, such as methylhydrazine hydrochloride, phenylhydrazine hydrochloride, benzylhydrazine oxalate, butylhydrazine hydrochloride, butylhydrazine oxalate salt, and propylhydrazine oxalate salt.

hydrazide, for example having the formula

RC(O)NHNH₂;

RC(O)NHNHR';

and

RC(O)NHNHC(O)R

wherein one or both nitrogen atoms are substituted by an acyl group of the formula RC(O), wherein each R is independently selected from hydrogen and a hydrocarbon group, and one or both nitrogen atoms are optionally mono- or di-substituted with R', wherein each R' is an independently selected hydrocarbon group. Illustrative examples of hydrazine are formic hydrazide, acethydrazide, benzhydrazide, adipic acid dihydrazide, carbohydrazide, butanolhydrazide, hexanoic hydrazide, octanoic hydrazide, oxamic acid hydrazide, maleic hydrazide, N-methylhydrazinecarboxamide, and semicarbazide;

carbazate or hydrazinocarboxylate, for example of the formula

ROC(O)NHNHR';

ROC(O)NHNH₂;

AND

ROC(O)NHNHC(O)

OR;
wherein one or both nitrogen atoms are substituted by an ester group of the formula ROC(O), wherein each R is independently selected from hydrogen and a hydrocarbon group, and one or both nitrogen atoms are optionally mono- or di-substituted with R', wherein each R' is an independently selected hydrocarbon group. Illustrative examples of carbazate are methyl carbazate (methyl hydrazinocarboxylate), ethyl carbazate, butyl carbazate, benzyl carbazate, and 2-hydroxyethyl carbazate;
sulfonohydrazide, for example of the formula

RSO₂NHNH₂;

RSO₂NHNHR';

and

RSO₂NHNHSO₂R;

wherein one or both nitrogen atoms are substituted by a sulfonyl group of the formula RSO₂, wherein each R is independently selected from hydrogen and a hydrocarbon group, and one or both nitrogen atoms are optionally mono- or di-substituted with R', wherein each R' is an independently selected hydrocarbon group. Illustrative examples of sulfonohydrazide are methanesulfonohydrazide, benzenesulfonohydrazine, 2,4,6-trimethylbenzenesulfonohydrazide, and p-toluenesulfonohydrazide.

Other exemplary hydrazine compounds are hydrazine acetate, aminoguanidine, thiosemicarbazide, methyl hydrazinecarbimidothiolate, and thiocarbohydrazide.

Unless otherwise indicated, in identifying the substituents for R and R' of the various hydrazine compounds, the phrase "hydrocarbon group" encompasses both unsubstituted and substituted hydrocarbon groups. Unsubstituted hydrocarbon groups may be, for example, a straight chain alkyl group, a branched alkyl group, a cycloalkyl group, an aryl group, an alkylaryl group, and an arylalkyl group. Exemplary alkyl groups include methyl, ethyl, propyl, butyl, pentyl, hexyl, heptyl, octyl, nonyl, decyl, undecyl, dodecyl, tridecyl, tetradecyl, pentadecyl, cyclopentyl, cyclohexyl, cycloheptyl, and isomeric forms thereof. Substituted hydrocarbon groups may be the unsubstituted hydrocarbon groups described herein which are substituted one, two, or more times with, for example, a halogen such as chlorine, bromine, fluorine, and iodine, nitro, cyano, an alkoxy group, such as methoxy, ethoxy, and propoxy, or a mixture thereof. In embodiments, the hydrocarbon group may be substituted alkyl, substituted aryl, or a combination thereof.

Any suitable reducing agent or combination of reducing agents can be used in embodiments herein. For example, one, two, three or more reducing agents may be used. Where two or more reducing agents are used, each reducing agent may be present at any suitable weight or molar ratios, such as first reducing agent:second reducing agent ratio of from about 99:1 to about 1:99. The total amount of reducing agent can be any suitable amount such as about 0.25 molar equivalent or more of reducing agent per mole of silver compound.

Any suitable stabilizer can be selected herein, wherein the stabilizer has the function of minimizing or preventing the metal-containing nanoparticles from aggregation in a liquid and optionally providing or enhancing the solubility or dispersiblity of metal-containing nanoparticles in a liquid. In addition, the stabilizer is thermally removable which means that the stabilizer can be caused to dissociate from the metal-containing nanoparticles surface under certain conditions such as through heating. The heating may be accomplished to a certain temperature such as for example, below about 250 °C, or below 200 °C, under normal atmospheric conditions or at a reduced pressure of, for example, from several millibars (mbars) to about 10 ⁻3 millibar (mbar). The thermal dissociation of the stabilizer from the metal-containing nanoparticles at a temperature such as lower than about 250 °C, may result in the evaporation of the stabilizer or decomposition of the stabilizer into gaseous form.

In embodiments, the present method provides low temperature processable metal nanoparticles having an annealing temperature of about from about 80 °C to about 150 °C, and in a specific embodiment having an annealing temperature of less than about 140 °C or less than about 130 °C, and in another specific embodiment having an annealing temperature of about 120 °C, and in another specific embodiment having an annealing temperature of about 110 °C. While not wishing to be bound by theory, in embodiments, the present process is believed to result in lower temperature annealing capability. The stabilizer, having a shorter carbon chain length than previous stabilizers, such as from about 6 to about 16 carbon atoms, contributes to the lower temperature annealing. For example, in specific embodiments, a stabilizer having a carbon chain length of about 12 carbon atoms carbon atoms is selected. In a specific embodiment, the stabilizer comprises a hydrocarbylamine containing from about 6 to about 16 carbon atoms. Further, the process wherein the reaction mixture is substantially free of solvent enables preparation of shorter chain organoamine stabilized silver nanoparticles having increased stabilization compared with the previous process using a solvent such as toluene. For example, dodecylamine stabilized silver-nanoparticles prepared with a solvent such as toluene would be degraded in a few days. However, dodecylamine stabilized silver nanoparticles prepared with the present method can remain stable for about several months or years. Thus, the present method enables preparation of low annealing temperature nanoparticles.

In embodiments, the stabilizer may be an organic stabilizer. The term "organic" in "organic stabilizer" refers to the presence of carbon atoms(s), but the organic stabilizer may include one or more non-metal heteroatoms such as nitrogen, oxygen, sulfur, silicon, halogen, and the like. Exemplary organic stabilizers include thiol and its derivatives, amine and its derivatives, carboxylic acid and its carboxylate derivatives, polyethylene glycols, and other organic surfactants. In embodiments, the organic stabilizer is selected from the group consisting of a thiol such as butanethiol, pentanethiol, hexanethiol, heptanethiol, octanethiol, decanethiol, and dodecanethiol; an amine such as ethylamine, propylamine, butylamine, pentylamine, hexylamine, heptylamine, octylamine, nonylamine, decylamine, and dodecylamine; a dithiol such as 1,2-ethanedithiol, 1,3-propanedithiol, and 1,4-butanedithiol; a diamine such as ethylenediamine, 1,3-diaminopropane, 1,4-diaminobutane; a mixture of thiol and a dithiol; and a mixture of an amine and a diamine. Organic stabilizers containing a pyridine derivative, for example dodecyl pyridine, and/or organophosphine that can stabilize silver-containing nanoparticles can also be selected.

In embodiments, the stabilizer is an organoamine such as butylamine, pentylamine, hexylamine, heptylamine, octylamine, nonylamine, decylamine, hexadecylamine, undecylamine, dodecylamine, tridecylamine, tetradecylamine, diaminopentane, diaminohexane, diaminoheptane, diaminooctane, diaminononane, diaminodecane, dipropylamine, dibutylamine, dipentylamine, dihexylamine, diheptylamine, dioctylamine, dinonylamine, didecylamine, methylpropylamine, ethylpropylamine, propylbutylamine, ethylbutylamine, ethylpentylamine, propylpentylamine, butylpentylamine, tributylamine, trihexylamine, and mixtures thereof. In a specific embodiment, the stabilizer is dodecylamine. In another specific embodiment, the stabilizer is a hydrocarbylamine having at least 4 carbon atoms. In another specific embodiment, the reducing agent is a phenylhydrazine and the stabilizer comprises dodecylamine.

One, two, three or more stabilizers may be used. In embodiments where two or more stabilizers are used, each stabilizer may be present at any suitable weight or molar ratios, such as a first stabilizer:second stabilizer ratio of about 99:1 to about 1:99. The total amount of the stabilizer can be any suitable amount such as 1, 2, 10, 25 or more molar equivalents of stabilizer per mole of metal compound.

In embodiments, the metal-containing nanoparticles may form a chemical bond with the stabilizer. The chemical names of the stabilizer provided herein are before formation of any chemical bond with the silver-containing nanoparticles. It is noted that the nature of the stabilizer may change with the formation of a chemical bond, but for convenience the chemical name prior to formation of the chemical bond is used.

The attractive force between the metal-containing nano-particles and the stabilizer can be a chemical bond, a physical attachment, or a combination thereof. The chemical bond can take the form of covalent bonding, hydrogen bonding, coordination complex bonding, ionic bonding, or a mixture of different chemical bonding. The physical attachment can take the form of van der Waals' forces or dipole-dipole interaction, or a mixture of different physical attachments.

The extent of the coverage of stabilizer on the surface of the metal-containing nanoparticles can vary such as from partial to full coverage depending, for example, on the capability of the stabilizer to stabilize the metal-containing nanoparticles. There is also variability in the extent of coverage of the stabilizer among the individual metal-containing nanoparticles.

The present process is for preparing stabilized, in embodiments organoamine-stabilized, metal-nanoparticles for applications including conductive ink applications. The method includes chemical reduction of a metal compound, in a reaction mixture that is substantially free of solvent, in embodiments, silver acetate with a reducing agent, such as phenylhydrazine, in the present of a stabilizer, such as an organoamine stabilizer. The metal nanoparticles formed during the present solvent-free reducing process are much more stable than metal nanoparticles prepared by previous methods including solvent based processes. The method herein eliminates the need for previously required environmentally harmful solvents such as toluene. The chemical reaction process herein further provides reduced production cost by substantially eliminating use of solvents. The method is particularly convenient for preparing low temperature processable metal nanoparticles, in a specific embodiment for preparing low temperature processable organoamine-stabilized silver nanoparticle inks having an annealing temperature in one embodiment of about 120 °C or less.

In embodiments, the reaction mixture is substantially free of any solvent. In specific embodiments, the total amount of any solvent is less than about 40 weight percent, or less than about 20 weight percent, or less than about 5 weight percent, based on the total weight of the reaction mixture, and in a specific embodiment wherein the reaction mixture is free of any solvent (that is, contains zero weight percent solvent).

The reaction of the silver compound with the reducing agent is carried out at any suitable temperature such as from about -50 °C to about 200 °C, or from about -25 °C to about 80 °C, or from about 0 °C to about 150 °C, or from about 20 °C to about 120 °C.

The mole ratio of stabilizer to metal compound can be any suitable mole ratio. In embodiments the mole ration of stabilizer to metal compound (stabilizer:silver salt) is no less than about 3 to 1, no less than about 4 to 1, or no less than about 5 to 1.

The metal-containing nanoparticles can have any suitable particle size such as less than about 100 nanometers (nm), less than about 50 nm, less than about 25 nm, or less than about 10 nm, although the particle size can be outside of these ranges. The particle size is defined herein as the average diameter of silver-containing particle core, excluding the stabilizer, as determined by transmission electron microscopy. Generally, a plurality of particle sizes may exist in the silver-containing nanoparticles obtained from the process. In embodiments, the existence of different sized silver-containing nanoparticles is acceptable.

Any suitable metal nanoparticle can be selected. In embodiments, the metal nanoparticle is selected from the group consisting of silver, gold, platinum, palladium, copper, cobalt, chromium, nickel, silver-copper composite, silver-gold-copper composite, silver-gold-palladium composite and mixtures thereof. In one specific embodiment, the metal-containing nanoparticles comprise silver metal or silver alloy composite. In further embodiments, the metal-containing nanoparticles comprise elemental silver or a silver composite. Besides silver, the composite can include either or both of (i) one or more other metals and (ii) one or more non-metals. Suitable other metals include Al, Au, Pt, Pd, Cu, Co, Cr, In, and Ni, and mixtures thereof, particularly the transition metals Au, Pt, Pd, Cu, Cr, Ni, and mixtures thereof. Exemplary metal composites are Au-Ag, Ag-Cu, Au-Ag-Cu, and Au-Ag-Pd. Suitable non-metals in the metal composite include Si, C, and Ge. The various components of the silver composite may be present in any suitable amount such as from about 0.01 % to about 99 % or from about 10 % to about 90 % by weight based upon the total weight of the silver nanoparticle. In embodiments, the silver composite is a metal alloy composed of silver and one, two or more other metals, with silver comprising at least about 20 % or greater than about 50 % of the nanoparticles by weight. Unless otherwise noted, the weight percentages recited herein for the components of the silver-containing nanoparticles do not include the stabilizer.

Metal-containing nanoparticles comprising a metal composite can be made by any suitable process such as by using a mixture of (i) a metal compound or compounds and (ii) another metal salt or salts or another non-metal or combination of non-metals in the reaction.

Metal-containing nanoparticle compositions can also be prepared by mixing metal-containing nanoparticles with other metal or non-metal nanoparticles.

Scavengers can be used to destroy excess reducing agent and can be any suitable scavenger such as ketone, aldehyde, carboxylic acid, or a mixture thereof. Specific exemplary scavengers include acetone, butanone, pentanone, formaldehyde, acetaldehyde, acetic acid, and mixtures thereof.

The present disclosure further describes a composition comprising a liquid and a plurality of metal-containing nanoparticles with a stabilizer, wherein the molecules of the stabilizer are on the surface of the metal-containing nanoparticles, wherein the metal-containing nanoparticles are a product of a reaction of a metal compound with a reducing agent comprising a hydrazine compound in the presence of a thermally removable stabilizer in a reaction mixture that is substantially free of solvent comprising the metal compound, the reducing agent, and the stabilizer.

The liquid that can be used to disperse or dissolve the metal-containing nanoparticles to form a metal-containing nanoparticle composition include organic liquids or water. Exemplary organic liquids include hydrocarbon solvents such as pentane, hexane, cyclohexane, heptanes, octane, nonane, decane, undecane, dodecane, tridecane, tetradecane, toluene, xylene, mesitylene, and the like; alcohols such as methanol, ethanol, propanol, butanol, and the like; tetrahydrofuran, chlorobenzene, dichlorobenzene, trichlorobenzene, nitrobenzene, cyanobenzene, acetonitrile; and mixtures and combinations thereof. One, two, three or more liquids may be used. In embodiments, where two or more liquids are used, each liquid may be present at any suitable volume or molar ratio such as a ratio of first liquid to second liquid of from about 99:1 to about 1:99.

The components of the metal-containing nanoparticle composition can be present in any suitable amount. Exemplary amounts include wherein the metal-containing nanoparticles and the stabilizer are present in an amount of form about 0.3 % to about 90 %, or from about 1 % to about 70 %, by weight, based upon the total weight of the nanoparticle composition, the balance being the other components of the composition such as the liquid.

In embodiments, the stabilizer present in the metal-containing nanoparticle composition originated from the reaction mixture for the preparation of metal-containing nanoparticles; no stabilizer is added subsequently for the formation of the metal-containing nanoparticles. In other embodiments, the same or a different stabilizer may be added subsequently from the formation of the metal-containing nanoparticles in any suitable amount such as from about 0.3 % to about 70 % by weight based upon the total weight of the metal-containing nanoparticle composition.

Stability herein means the time period where there is minimal or no precipitation or aggregation of the metal-containing nanoparticles. The metal-containing nanoparticle herein has a stability of at least about 3 hours, or form about 3 hours to about 1 month, or from about 1 day to about 3 months, or from about 1 day to about 6 months, or from about 1 week to over one year. In embodiments herein, the metal-containing nanoparticle composition herein has a stability of from about 3 hours to about 1 day, or from about 1 day to about one week, or from about 1 day to about 1 month, or from about 1 day to about 6 months, or from about 1 day to about 1 year, or from about 1 day to over 1 year. In one embodiment, the metal-containing nanoparticle composition herein has a stability of more than two months at a temperature of about 25 °C. In another embodiment, the metal-containing nanoparticle composition herein has a stability of more than three months at a temperature of from about 25 °C. In another embodiment, the stabilized metal nanoparticles maintain the annealing temperature for at least 7 days when the composition is stored at about 60 °C or lower. In another embodiment, the metal-nanoparticle composition has a stability of at least 7 days when the composition is stored at about 60 °C or lower.

The fabrication of an electrically conductive element from the metal-containing nanoparticle composition can be carried out by depositing the composition on a substrate using a liquid deposition technique at any suitable time prior to or subsequent to the formation of other optional layer or layers on the substrate. Thus, liquid deposition of the composition on the substrate can occur either on a substrate or on a substrate already containing layered material, for example, a semiconductor layer, and insulating layer or a combination thereof.

The phrase "liquid deposition technique" refers to deposition of a composition using a liquid process such as liquid coating or printing, where the liquid is a solution or a dispersion. The metal-containing nanoparticle composition may be referred to as an ink when printing is used. Illustrative liquid coating processes include spin coating, blade coating, rod coating, dip coating, and the like. Illustrative printing techniques include lithography or offset printing, gravure, flexography, screen printing, stencil printing, inkjet printing, stamping, such as microcontact print, and the like. Liquid deposition deposits a layer of the composition having a thickness of from about 5 nanometers to about 5 millimeters, or from about 10 nanometers to about 1,000 micrometers. The deposited metal-containing nanoparticle composition at this stage may or may not exhibit appreciable electrical conductivity.

As used herein, the term "heating" encompasses any technique or combination of techniques that can impart sufficient energy to the heated material to cause the desired result such as thermal heating, for example with a hot plate, an oven, or a burner, infrared radiation, microwave radiation, ultraviolet radiation, or a combination thereof.

The present method provides lower temperature annealing than previous available, such as, in embodiments, low temperature processable metal nanoparticles having an annealing temperature of about from about 70 °C to about 150 °C, and in a specific embodiment having an annealing temperature of less than about 130 °C, and in another specific embodiment having an annealing temperature of about 120 °C. Heating the deposited composition at a suitable temperature causes the metal-containing nanoparticles to form an electrically conductive layer which is suitable for use as an electrically conductive element in electronic devices. The heating temperature selected preferably is one that does not cause adverse changes in the properties of previously deposited layers or in the single layer or multi layer substrate. The heating is performed for any suitable time, such as for from about 1 second to about 10 hours, or from about 10 seconds to about 1 hour. The heating can be performed in air, in an inert atmosphere such as under nitrogen or argon, or in a reducing atmosphere such as under nitrogen containing form about 1 to about 20 percent by volume hydrogen. The heating can be performed under normal atmospheric conditions or at a reduced pressure such as from several mbars to about 10 ^{_3} mbar.

Heating can produce a number of effects. Prior to heating, the layer of the deposited metal-containing nanoparticles may be electrically insulating or have very low electrical conductivity, but heating results in an electrically conductive layer composed of annealed metal-containing nanoparticles which increases the conductivity. In embodiments, the annealed metal-containing nanoparticles may be coalesced or partially coalesced metal-containing nanoparticles. Alternately, the annealed metal-containing nanoparticles may achieve sufficient particle-to-particle contact to form the electrically conductive layer without coalescence.

Heating may cause separating of the stabilizer and the liquid from the metal-containing nanoparticles in the sense that the stabilizer and the liquid are generally not incorporated into the electrically conductive layer but if present are present in residual quantities. In embodiments, heating may decompose a portion of the stabilizer to produce "decomposed stabilizer." Heating may also cause separation of the decomposed stabilizer such that the decomposed stabilizer generally is not incorporated into the electrically conductive layer, but if present, is present in a residual amount. Separation of the stabilizer, the liquid, and the decomposed stabilizer from the metal-containing nanoparticles may lead to enhanced electrical conductivity of the resulting electrically conductive layer since the presence of these components may reduce the extent of metal-containing particle to metal-containing nanoparticle contact or coalescence. Separation may occur in any manner such as by a change in state of matter form a solid or liquid to a gas, for example volatilization.

In embodiments, one or more of the stabilizer, decomposed stabilizer, and the liquid is absent from the electrically conductive layer. In embodiments, a residual amount of one or more of the stabilizer, decomposed stabilizer, and the liquid may be present in the electrically conductive layer, where the residual amount does not appreciably affect the conductivity of the electrically conductive layer. In embodiments, the residual amount of one or more of stabilizer, decomposed stabilizer, and the liquid may decrease the conductivity of the electrically conductive layer but the resulting conductivity is still within the useful range for the intended electronic device. The residual amount of each component may be any suitable amount such as up to about 5 %, or less than about 0.5 %, by weight based on the weight of the electrically conductive layer, depending on the process conditions such as heating temperature and time. When heating causes separation of the stabilizer and/or the decomposed stabilizer from the metal-containing nanoparticles, the attractive force between the separated stabilizer/decomposed stabilizer and the metal-containing nanoparticles is severed or diminished. Other techniques such as exposure to ultraviolet radiation, microwave radiation, or infrared radiation may be used or combined with thermal heating to accelerate the separation of the liquid and the stabilizer and/or the decomposed stabilizer from the metal-containing nanoparticles.

After heating, the resulting electrically conductive layer can have any suitable thickness such as a thickness of from about 5 nanometers to about 5 millimeters, or from about 10 nanometers to about 1,000 micrometers.

The conductivity of the resulting metal-containing element produced by heating the deposited metal-containing nanoparticle composition is, for example, more than about 0.1 Siemens/centimeter (S/cm), more than about 500 S/cm, more than about 2,000 S/cm, more than about 5,000 S/cm, more than about 10,000 S/cm, or more than about 20,000 S/cm, or, in a specific embodiment, 100,000 S/cm, as measured by the conventional four probe method. In embodiments, the metal-containing nanoparticles comprise silver nanoparticles having an annealing temperature of lower than about 140 °C, at which the silver nanoparticles form a metal framework with a conductivity of at least about 5,000 S/cm. In embodiments, the metal-containing nanoparticles comprise silver nanoparticles having an annealing temperature of lower than about 130 °C, at which the silver nanoparticles form a metal framework with a conductivity of at least about 5,000 S/cm. In further embodiments, the silver-containing nanoparticles maintain the annealing temperature for at least about 7 days when the silver nanoparticles are stored at a temperature of about 60 °C or lower.

The resulting conductive elements can be used as conductive electrodes, conductive pads, conductive traces, conductive elements, conductive tracks, and the like, in electronic devices. The phrase "electronic device" refers to macro- micro- and nano-electronic devices such as thin film transistor, organic light emitting diodes, radiofrequency identification tags, photovoltaics, and other electronic devices which require conductive elements or components.

In embodiments, the metal-containing nanoparticle composition can be used to fabricate conductive components such as source and drain electrodes in thin film transistors (TFT). See U. S. Patents 7,270,694 and 7,494,608, for a description of possible TFT configurations.

### EXAMPLES

The following Examples are being submitted to further define various species of the present disclosure. These Examples are intended to be illustrative only and are not intended to limit the scope of the present disclosure. Also, parts and percentages are by weight unless otherwise indicated.

### Example 1

5.0 grams of silver acetate and 55.5 grams of dodecylamine were added to a 250 milliliter reaction flask. The mixture was heated and stirred for about 10 to 20 minutes at 55 to 60 °C until the dodecylamine and silver acetate were dissolved. 1.78 grams of phenylhydrazine was added to the above liquid drop-wise with vigorous stirring at 55 °C. The color of liquid changed from clear to dark brown indicating the formation of silver nanoparticles. The mixture was further stirred for one hour at 55 °C and then was cooled down to 40 °C. After the temperature reached 40 °C, 120 milliliters of methanol was added with good stirring. The precipitate was filtered and rinsed briefly with methanol. The solid was dried under vacuum overnight at room temperature, yielding 3.5 grams of silver nanoparticles with 79 weight percent of silver content.

### Example 2

A solution of the silver nanoparticles of Example 1 in toluene (15 weight percent silver nanoparticles) was spin coated on a glass slide at 100 rpm for 2 minutes and a brown thin film of silver nanoparticles was obtained. The thin film on the glass was heated in an oven at 120 °C for 10 minutes to yield a shiny mirror-like thin film having a thickness of 92.5 nanometers. The conductivity of the annealed film was 2.9 X 10⁴ S/cm, which was measured using the conventional four-probe technique. The coating solution of the silver nanoparticles is stable for more than 7 days without precipitation at room temperature.

### Example 3

A solution of the silver nanoparticles of Example 1 (50 weigh percent silver nanoparticles) in a mixed solvents solution of Isopar™ "G" (aliphatic hydrocarbon, available from Exxon Mobil Chemical) and terpineol (monoterpene alcohol, available from Fluka), 2 to 1 by volume, was prepared. A set of thin lines (1 millimeter long) was obtained by inkjet printing the above prepared silver nanoparticle ink solution on a glass substrate. The printed pattern on the glass was heated in an oven at 120 °C for 10 minutes to yield shiny mirror-like thin lines having a thickness of about 60 to about 80 nanometers and a width of about 95 to about 125 micrometers. The averaged conductivity of the annealed lines was 1.16 X 10⁵ S/cm.

### Example 4

The prepared silver-nanoparticles of Example 1 were stored in a glass container which was placed in a vacuum oven at room temperature. The stability was tested after 1 month, 2 months, 3 months, and 4 months of shelf life by measuring conductivity accordingly. The test method and sample preparations for the tests were described in Example 2 and the conductivity results of the aged silver nanoparticles are summarized in the following Table. All of the thin films on glass slides were annealed in an oven in a temperature range of about 110 to about 120 °C for about 10 minutes.

**Table 1**

| Sample Shelf Time | Film thickness (nm) | Conductivity (S/cm) |
|---|---|---|
| Fresh prepared | 93 | 29400 |
| 1 month | 88 | 26000 |
| 2 months | 102 | 27100 |
| 3 months | 110 | 41400 |
| 4 months | 85 | 41700 |

### Comparative Example 5

5.0 grams of silver acetate, 55.5 grams of dodecylamine and 25 milliliters of toluene were added to a 250 milliliter reaction flask. The mixture was heated and stirred for about 10 to 20 minutes at 55 to 60 °C until the dodecylamine and silver acetate were dissolved. 1.78 grams of phenylhydrazine in toluene (5 ML) was added to the above liquid drop-wise with vigorous stirring at 55 °C. The color of liquid changed from clear to dark brown indicating the formation of silver nanoparticles. The mixture was further stirred for one hour at 55 °C and then was cooled down to 40 °C. After the temperature reached 40 °C, 120 milliliters of methanol was added with good stirring. The precipitate was filtered and rinsed briefly with methanol. The solid was dried under vacuum overnight at room temperature, yielding 3.2 grams of silver nanoparticles with 83.5 weight percent of silver content.

### Comparative Example 6

The prepared silver-nanoparticles of Comparative Example 5 were disposed in a glass container and stored in a vacuum oven at room temperature. Stability was tested after 1 week and after 2 weeks of shelf life by measuring conductivity accordingly. The test method and sample preparations for the tests were described in example 2 and the conductivity results of the aged silver nanoparticles are summarized in the following Table. All of the thin films on glass slides were annealed in an oven in a temperature range of 110 to 120 °C for about 10 minutes.

**Table 2**

| Sample Shelf Time | Film thickness (nm) | Conductivity (S/cm) |
|---|---|---|
| Fresh prepared | 89 | 17500 |
| 1 week | 65 | 2300 |
| 2 weeks | film quality because of bad solubility | Not conductive |

In embodiments, organoamine-stabilized silver nanoparticles prepared by the present method have greater stability than silver nanoparticles prepared by previous methods. Further, in embodiments, the present method reduces or eliminates use of environmentally harmful solvents, such as toluene, from the chemical reaction process. The present method further provides a reduction in production cost by eliminating unnecessary solvent.

## Claims

1. A process for preparing stabilized metal nanoparticles, the process comprising:
reacting a metal compound with a reducing agent in the presence of a stabilizer in a reaction mixture comprising the metal compound, the reducing agent, and the stabilizer, wherein the reaction mixture is substantially free of solvent, to form a plurality of metal-containing nanoparticles during the solvent-free reducing process with molecules of the stabilizer on the surface of the metal-containing nanoparticles.

2. The process of claim 1, further comprising isolating the stabilized metal nanoparticles from the reaction mixture.

3. The process of claim 1, wherein the total amount of solvent is less than about 20 weight percent based on the total weight of the reaction mixture.

4. The process of claim 1, wherein the metal nanoparticle is selected from the group consisting of silver, gold, platinum, palladium, copper, cobalt, chromium, nickel, silver-copper composite, silver-gold-copper composite, silver-gold-palladium composite and mixtures thereof, or
wherein the metal-containing nanoparticles comprise silver metal or silver alloy composite, or
wherein the metal compound comprises a metal salt selected the group consisting of metal acetate, metal trifluoroacetate, metal halide, metal sulfate, metal nitrate, metal hydrocarbylsulfonate, or a mixture thereof.

5. The process of claim 1, wherein the reducing agent comprises a boron compound or a hydrazine compound.

6. The process of claim 1, wherein the reducing agent comprises a hydrazine compound selected from the group consisting of hydrazine or its corresponding salt, a hydrocarbylhydrazine, a hydrocarbylhydrazinium salt, a carbohydrazide, a semicarbazide, a sulfonohydrazide, or a mixture thereof.

7. The process of claim 1, wherein the stabilizer includes an organoamine comprising a hydrocarbylamine having at least 4 carbon atoms, or
wherein the mole ratio of stabilizer to the metal compound is at least about 3 to 1, or
wherein the stabilizer is selected from the group consisting of butylamine, pentylamine, hexylamine, heptylamine, octylamine, nonylamine, decylamine, hexadecylamine, undecylamine, dodecylamine, tridecylamine, tetradecylamine, diaminopentane, diaminohexane, diaminoheptane, diaminooctane, diaminononane, diaminodecane, dipropylamine, dibutylamine, dipentylamine, dihexylamine, diheptylamine, dioctylamine, dinonylamine, didecylamine, methylpropylamine, ethylpropylamine, propylbutylamine, ethylbutylamine, ethylpentylamine, propylpentylamine, butylpentylamine, tributylamine, trihexylamine and mixtures thereof.

8. The process of claim 1, wherein the metal-containing nanoparticles comprise silver nanoparticles having an annealing temperature of lower than about 140 °C, and wherein the silver nanoparticles form a metal framework with a conductivity of at least about 5,000 S/cm.

9. The process of claim 1, wherein the reaction of the metal compound with the reducing agent is carried out at a temperature of from about -25 °C to about 80 °C, or wherein the reducing agent is a phenylhydrazine and the stabilizer comprises dodecylamine.

10. A composition comprising a liquid and a plurality of metal-containing nanoparticles with a stabilizer attached on the surface of the metal-containing nanoparticles, wherein the metal-containing nanoparticles are the product of a reaction of a metal compound with a reducing agent in the presence of a stabilizer in a reaction mixture comprising the metal compound, the reducing agent, and the stabilizer, wherein said reaction mixture is substantially free of solvent.

11. The composition of claim 10, wherein the metal-containing nanoparticles comprise a stabilizer comprised of a hydrocarbylamine containing from about 6 to about 16 carbon atoms.

12. The composition of claim 10, wherein the metal-containing nanoparticles comprise a stabilizer comprised of dodecylamine.

13. The composition of claim 12, wherein the metal nanoparticles possess an annealing point of lower than about 130 °C, at which temperature the metal nanoparticles form a metal framework with a conductivity of at least 5,000 S/cm.

14. A process for forming a conductive metal framework comprising:
reacting a metal compound with a reducing agent in the presence of a thermally removable stabilizer in a reaction mixture comprising the metal compound, the reducing agent, and the stabilizer, wherein said reaction mixture is substantially free of solvent, to form a plurality of metal-containing nanoparticles during the solvent-free reduction process with molecules of the stabilizer on the surface of the metal-containing nanoparticles;
isolating the plurality of metal-containing nanoparticles with the molecules of the stabilizer on the surface of the metal-containing nanoparticles;
preparing a composition including a liquid and the plurality of metal-containing nanoparticles with molecules of the stabilizer on the surface of the metal-containing nanoparticles;
depositing the composition including a liquid and the plurality of metal-containing nanoparticles with molecules of the stabilizer on the surface of the metal-containing nanoparticles on a substrate by a liquid deposition technique to form a deposited composition; and
heating the deposited composition to form an electrically conductive layer comprising metal.

15. The process of claim 14, wherein the heating is accomplished at a temperature below about 130 °C.
